# EUROPEAN PATENT APPLICATION

(11) **EP 4 545 607 A1**
(43) Date of publication of application: **30.04.2025**
(21) Application number: 23826198.6
(22) Date of filing: 12.06.2023
(51) Int. Cl.: C09D 11/101, B65G 65/22, C07D 305/06, G03F 7/004, C08G 77/14

(54) **CATIONIC PHOTOCURABLE COMPOSITION AND USE THEREOF**

(30) Priority: 24.06.2022 CN 202210726323
(71) Applicant: Changzhou Zhengjie Intelligent Manufacture Technology Co., Ltd., Changzhou, Jiangsu 213100 (CN)
(72) Inventor: QIAN, Bin, hangzhou, Jiangsu 213100 (CN)
(74) Representative: Dilg, Haeusler, Schindelmann Patentanwaltsgesellschaft mbH
(86) International application number: PCT/CN2023/099730
(87) International publication number: WO 2023/246549

(57) **Abstract**

Provided in the present invention are a cationic photocurable composition and use thereof. The composition comprises: in parts by weight, 10-30 parts of a first cationic polymerizable compound, 10-65 parts of a second cationic polymerizable compound, 20-60 parts of an epoxy compound or / and an oxetane compound, 1-10 parts of a cationic initiator, and 2-20 parts of a pigment, wherein the first cationic polymerizable compound and the second cationic polymerizable compound have structures shown in Structural Formula I and Structural Formula II; in the formulas, R₀ is selected from hydrogen, a methyl, and an ethyl, R₁ represents a methyl or ethyl, n is 1 or 2, and R₂ represents a methyl or ethyl; and the sum of the contents of the first cationic polymerizable compound and the second cationic polymerizable compound accounts for 30-75 wt% of the total amount of the cationic photocurable composition. The composition can improve the ink dot density fluctuation after the ink is applied, can enhance the optical density, and has good adhesion and a high curing speed.

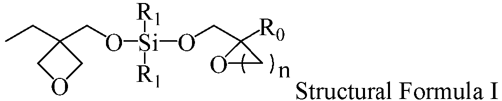

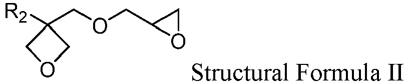

## Description

### TECHNICAL FIELD

The present invention relates to the technical field of photocuring, and specifically relates to a cationic photocurable composition and use thereof.

### BACKGROUND

In recent years, inkjet printing has been widely used in electronic devices, display devices, color filters, commercial printing and other printing fields, since it can produce images easily and cheaply. Commonly used inkjet inks mainly include three categories: water-based inkjet inks, solvent-based inkjet inks, and active energy ray-curable inkjet inks. Among them, active energy ray-curable inkjet inks can form the desired pattern quickly in a non-contact manner, and are suitable for printing on a variety of recording media and thus are widely used.

In the inkjet printing, the ink ejected from the nozzle of the inkjet head spreads to a predetermined size and forms dots after landing on the substrate. When the dot density is small, the ink cannot cover the surface of the substrate and blank parts are left, so the OD value (optical density) decreases and consequently a high-definition printed pattern cannot be obtained.

To solve this problem, many improvements focus on pigments to improve the OD value (optical density), or attempt to solve it by increasing image resolution or increasing the ink amount per dot. However, as the pigment concentration increases, the stability of the composition would decrease. In order to improve image quality by reducing the droplet size, the sensitivity is significantly reduced. At the same time, increasing the ink amount per dot is easy to experience infiltration phenomenon. In addition, it is difficult to achieve the OD value required by the product by adjusting the spacing between inkjet droplets, with poor operability.

Active energy ray-curable inkjet inks mainly include two categories: free radical polymerization inkjet inks using vinyl compounds and cationic polymerization inkjet inks using epoxy compounds and vinyl ether compounds. The free radical polymerization inkjet inks are widely used in practice due to their wide range of material selection, but they are greatly affected by oxygen inhibition, and the ink is not fully cured. When forming images on non-absorbent substrates such as plastics, glasses, and metals, uncured inks bleed and the image quality deteriorates. The cationic polymerization inkjet inks are not hindered by oxygen, but existing cationic polymerization inks are affected by the type of recording materials, especially non-absorbent substrates such as plastics, glasses, and metals, such that the dot density after landing is prone to being reduced, thereby reducing the OD value (optical density). Thus, it is not possible to form high-definition images on a variety of recording materials. Improving the OD value of the cationic inkjet ink is of great significance for improving the comprehensive performance of the inkjet printing.

### SUMMARY

The main purpose of the present invention is to provide a cationic photocurable composition and use thereof, so as to solve the problem that the existing cationic polymeric inks have lower OD value.

In order to achieve the above purpose, according to one aspect of the present invention, there is provided a cationic photocurable composition, characterized in comprising: 10-30 parts by weight of a first cationic polymerizable compound, 10-65 parts by weight of a second cationic polymerizable compound, 20-60 parts by weight of an epoxy compound or/and an oxetane compound, 1-10 parts by weight of a cationic initiator, and 2-20 parts by weight of a pigment, wherein the first cationic polymerizable compound is any one or more of the compounds shown by Structural Formula I, and the second cationic polymerizable compound is any one or more of the compounds shown by Structural Formula II; in the formulae, R₀ is selected from any one of hydrogen, methyl, and ethyl, R₁ represents methyl or ethyl, n is 1 or 2; and R₂ represents methyl or ethyl; 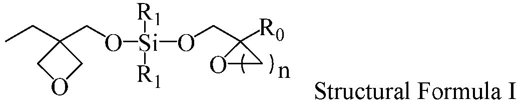 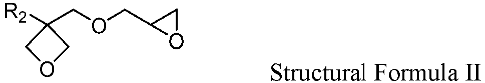 the sum of the contents of the first cationic polymerizable compound and the second cationic polymerizable compound accounts for 30 wt% to 75 wt% of the total content of the cationic photocurable composition.

Further, the first cationic polymerizable compound is 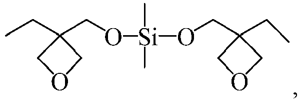 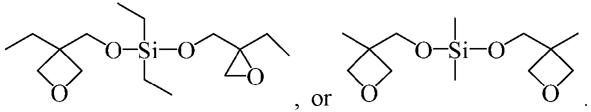 Preferably, the second cationic polymerizable compound is

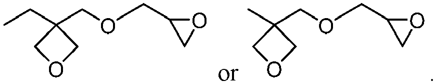

Further, the epoxy compound includes any one or more selected from 3,4-epoxycyclohexylmethyl 3,4-epoxycyclohexylformate, 3,4-epoxycyclohexylmethyl-3,4-epoxycyclohexanecarboxylate, bis(3,4-epoxycyclohexylmethyl)adipate, caprolactone-modified compound of 3,4-epoxycyclohexylmethyl-3,4-epoxycyclohexanecarboxylate, ester compound of polyvalent carboxylic acid with 3,4-epoxycyclohexylmethyl alcohol or caprolactone-modified compound thereof, silicone-based compound having an alicyclic epoxy group at the terminal, bisphenol A diglycidyl ether, bisphenol F diglycidyl ether, brominated bisphenol A diglycidyl ether, phenol novolac epoxy resin, cresol novolac epoxy resin, biphenyl epoxy resin, diglycidyl terephthalate, diglycidyl phthalate, addition reaction product of terminal carboxylic acid polybutadiene with bisphenol A epoxy resin, dicyclopentadiene dioxide, limonene dioxide, 4-vinylcyclohexene dioxide, polyethylene glycol diglycidyl ether, polypropylene glycol diglycidyl ether, polytetramethylene glycol diglycidyl ether, hydrogenated bisphenol A diglycidyl ether, epoxidized vegetable oil, 2-(3,4-epoxycyclohexyl)ethyltrimethoxysilane, 2-(3,4-epoxycyclohexyl)ethyltriethoxysilane, 3-glycidyloxypropyltrimethoxysilane, and 3-glycidyloxypropylmethyldimethoxysilane;
or/and, the oxetane compound includes any one or more selected from 3-benzyloxymethyl-3-ethyloxetane, 3-ethyl-3-(phenoxymethyl)oxetane, 3,3'-[2-(benzyloxy)propane-1,3-dimethoxydiethyloxetane], 3-ethyl-3-methoxyoxetane methacrylate.

Further, the cationic initiator includes an iodonium salt photoinitiator and/or a sulfonium salt photoinitiator; optionally, the cationic initiator is selected from any one or more of diaryliodonium salts of arsenic acid, diaryliodonium salts of sulfonic acid, triarylsulfonium salts of sulfonic acid, diaryliodonium salts of boric acid, triarylsulfonium salts of boric acid, diaryliodonium salts of phosphoric acid, triarylsulfonium salts of phosphoric acid, diaryliodonium salts of antimonic acid, and triarylsulfonium salts of antimonic acid.

Further, the pigment is an organic pigment and/or an inorganic pigment. The color of the pigment includes any one or more of black, blue, brown, cyan, green, white, purple, magenta, red, orange, and yellow.

Further, the cationic photocurable composition further comprises a sensitizer.

Preferably, the sensitizer has a content of 0.1 wt% to 10 wt%, more preferably 3 wt% to 8 wt%, in the cationic photocurable composition.

Preferably, the sensitizer includes any one or more selected from thioxanthone compounds, xanthone compounds, acridine compounds, anthracene compounds, and coumarin compounds. More preferably, the sensitizer is selected from any one or more of anthracene compounds and thioxanthone compounds.

Further, the sum of the contents of the first cationic polymerizable compound and the second cationic polymerizable compound accounts for 30 wt% to 60 wt% of the cationic photocurable composition, and the amount ratio of the first cationic polymerizable compound to the second cationic polymerizable compound is 1:5 to 3:1.

Further, the cationic photocurable composition further comprises an auxiliary. The auxiliary includes any one or more of levelling agents, dispersants, curing agents, surfactants, defoamers, and storage enhancers.

Further, the viscosity of the cationic photocurable composition is less than 50 mPa·s. Preferably, the viscosity is 2 to 30 mPa·s.

According to another aspect of the present invention, there is provided use of any of the aforementioned cationic photocurable compositions in an ink.

Further, the substrate used for the ink includes any of film, glass, and plastic.

Preferably, the ink has a spraying thickness of 0.1 to 10 µm, more preferably 0.5 to 5 µm.

By applying the technical solution of the present invention, the cationic polymerizable compounds having specific structures are used to combine in a specific proportion while simultaneously adding the epoxy compound or/and oxetane compound. Under the synergistic effect of the above cationic polymerizable compounds and the epoxy compound or/and oxetane compound, the cationic polymerizable composition is not susceptible to be affected by humidity, can effectively improve the dot density fluctuation after the ink landing, and can increase the optical density, so that high-precision images can be formed on various types of recording materials. Also, it has good adhesion and a high curing speed. When being used as an ink, it can effectively expand the range of application for the cationic polymeric ink.

### DESCRIPTION OF EMBODIMENTS

It should be noted that, in the case of no conflict, the embodiments in the subject application as well as the features therein can be combined with each other. The invention will be described in detail below with reference to the embodiments.

As analyzed in the BACKGROUND of the subject application, the dot density of cationic photocuring inks in the prior art after landing easily decreases, leading to the decrease in OD value (optical density), and consequently it is difficult to form high-precision images on various recording materials. In order to solve this problem, there is provided a cationic photocurable composition and use thereof.

According to a typical embodiment of the present invention, there is provided a cationic photocurable composition comprising: 10-30 parts by weight of a first cationic polymerizable compound, 10-65 parts by weight of a second cationic polymerizable compound, 20-60 parts by weight of an epoxy compound or/and an oxetane compound, 1-10 parts by weight of a cationic initiator, and 2-20 parts by weight of a pigment, wherein the first cationic polymerizable compound is any one or more of the compounds shown by Structural Formula I, and the second cationic polymerizable compound is any one or more of the compounds shown by Structural Formula II: 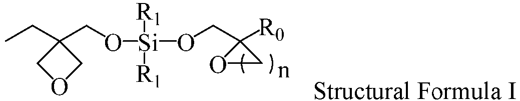 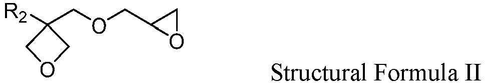 in the formulae, R₀ is selected from any one of hydrogen, methyl, and ethyl, R₁ represents methyl or ethyl, n is 1 or 2, and R₂ represents methyl or ethyl; and the sum of the contents of the first cationic polymerizable compound and the second cationic polymerizable compound accounts for 30 wt% to 75 wt% of the total content of cationic photocurable composition.

In the present invention, the cationic polymerizable compounds having a specific structure are used to combine in a specific proportion while simultaneously adding the epoxy compound or/and oxetane compound. Under the synergistic effect of the above cationic polymerizable compounds and the epoxy compound or/and oxetane compound, the cationic polymerizable composition is not susceptible to be affected by humidity, can effectively improve the dot density fluctuation after the ink landing, and can increase the optical density, so that high-precision images can be formed on various types of recording materials. Also, it has good adhesion and a high curing speed. When used as an ink, it can effectively expand the range of application for the cationic polymeric ink.

In some preferred embodiments of the present invention, the aforementioned first cationic polymerizable compound is 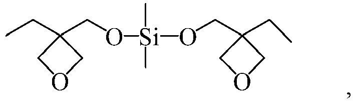 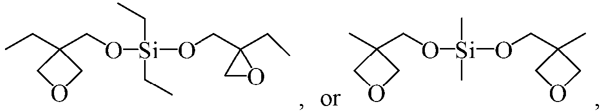 which is relatively simple to prepare, but also can have better synergistic effect with the second cationic polymerizable compound, the epoxy compound or/and the oxetane compound to further improve the optical density. Preferably, the second cationic polymerizable compound is 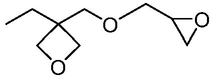 or 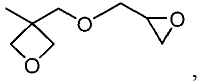 which has a significant effect on improving the performance of the composition, especially the OD value and adhesion.

The cationic photocurable composition of the present invention may contain both the epoxy compound and the oxetane compound, or may contain either of them. The specific types of the epoxy compound and the oxetane compound may be selected from the prior art and are not limited herein.

In some embodiments of the present invention, the aforementioned epoxy compound includes any one or more selected from 3,4-epoxycyclohexylmethyl 3,4-epoxycyclohexylformate, 3,4-epoxycyclohexylmethyl-3,4-epoxycyclohexanecarboxylate, bis(3,4-epoxycyclohexylmethyl)adipate, caprolactone-modified compound of 3,4-epoxycyclohexylmethyl-3,4-epoxycyclohexanecarboxylate, ester compound of polyvalent carboxylic acid with 3,4-epoxycyclohexylmethyl alcohol or caprolactone-modified compound thereof, silicone-based compound having an alicyclic epoxy group at the terminal, bisphenol A diglycidyl ether, bisphenol F diglycidyl ether, brominated bisphenol A diglycidyl ether, phenol novolac epoxy resin, cresol novolac epoxy resin, biphenyl epoxy resin, diglycidyl terephthalate, diglycidyl phthalate, addition reaction product of terminal carboxylic acid polybutadiene with bisphenol A epoxy resin, dicyclopentadiene dioxide, limonene dioxide, 4-vinylcyclohexene dioxide, polyethylene glycol diglycidyl ether, polypropylene glycol diglycidyl ether, polytetramethylene glycol diglycidyl ether, hydrogenated bisphenol A diglycidyl ether, epoxidized vegetable oil, 2-(3,4-epoxycyclohexyl)ethyltrimethoxysilane, 2-(3,4-epoxycyclohexyl)ethyltriethoxysilane, 3-glycidyloxypropyltrimethoxysilane, and 3-glycidyloxypropylmethyldimethoxysilane.

In some embodiments of the present invention, the aforementioned oxetane compound includes any one or more selected from 3-benzyloxymethyl-3-ethyloxetane, 3-ethyl-3-(phenoxymethyl)oxetane, 3,3'-[2-(benzyloxy)propane-1,3-dimethoxydiethyloxetane], 3-ethyl-3-methoxyoxetane methacrylate, and TCM series products and THM series products produced by TRONLY. Preferably, the amount of the epoxy compound and/or oxetane compound used in the cationic photocurable composition is 30 to 55 wt%, such as 35 wt%, 40 wt%, 45 wt%, 50 wt%, which can further improve the curing and drying speed of the composition.

In some preferred embodiments of the present invention, the content of the aforementioned epoxy compound and/or oxetane compound is 30 wt% to 50 wt% of the total amount of the cationic photocurable composition, and the printed pattern of the composition has a higher OD value and a better comprehensive performance such as appearance.

The aforementioned cationic initiator can be selected from the prior art. For example, the cationic initiator is selected from iodonium salt and/or sulfonium salt photoinitiators. In some embodiments of the present invention, the cationic initiator is selected from any one or more of diaryliodonium salts of arsenic acid, diaryliodonium salts of sulfonic acid, triarylsulfonium salts of sulfonic acid, diaryliodonium salts of boric acid, triarylsulfonium salts of boric acid, diaryliodonium salts of phosphoric acid, triarylsulfonium salts of phosphoric acid, diaryliodonium salts of antimonic acid, and triarylsulfonium salts of antimonic acid, which can further accelerate the curing speed of the aforementioned cationic photocurable composition.

Illustratively, the aforementioned cationic initiator can be selected from any one or more of 4-phenylthiotriphenylsulfonium hexafluoroantimonate, 4-phenylthiotriphenylsulfonium hexafluorophosphate, 4-phenylthiotriphenylsulfonium camphorsulfonate, 4-phenylthiotriphenylsulfonium tetra(pentafluorophenyl)borate, thioparaphenylenebis(4,4'-dimethyldiphenylsulfonium) bistetra(pentafluorophenyl)borate, tri(3-fluoro-4-methylphenyl)sulfonium hexafluorophosphate, 4,4'-ditolyliodonium hexafluorophosphate, 4,4'-ditolyliodonium tetra(pentafluorophenyl)borate, bis(4-tert-butylphenyl)iodonium hexafluorophosphate, bis(4-tert-butylphenyl)iodonium hexafluoroantimonate, bis(4-tert-butylphenyl)iodonium trifluoromethanesulfonate, diphenyliodonium hexafluorophosphate, 4-isobutyl-4'-methyldiphenyliodonium tetra(pentafluorophenyl)borate, (4-methyl-4'-isobutyl)diphenyliodonium hexafluorophosphate, bis(2,4,6-trimethylpyridyl)iodonium hexafluorophosphate, thioparaphenylenebis(4,4'-dimethyldiphenylsulfonium) bishexafluoroantimonate, bis(dodecylphenyl)iodonium hexafluoroarsenate, bis(dodecylphenyl)iodonium hexafluoroantimonate, dialkylphenyliodonium hexafluoroantimonate, diaryliodonium salts of perfluoroalkylsulfonic acid, diaryliodonium salts of perfluorobutanesulfonic acid, diaryliodonium salts of perfluoroethanesulfonic acid, diaryliodonium salts of perfluorococtanesulfonic acid, diaryliodonium salts of trifluoromethanesulfonic acid, diaryliodonium salts of paratoluenesulfonic acid, diaryliodonium salts of dodecylbenzenesulfonic acid, diaryliodonium salts of benzenesulfonic acid, diaryliodonium salts of 3-nitrobenzenesulfonic acid, triarylsulfonium salts of perfluorobutanesulfonic acid, triarylsulfonium salts of perfluoroethanesulfonic acid, triarylsulfonium salts of perfluorooctanesulfonic acid, triarylsulfonium salts of trifluoromethanesulfonic acid, triarylsulfonium salts of paratoluenesulfonic acid, triarylsulfonium salts of dodecylbenzenesulfonic acid, triarylsulfonium salts of benzenesulfonic acid, triarylsulfonium salts of 3-nitrobenzenesulfonic acid, diaryliodonium salts of perhalogenoarylboric acid, and triarylsulfonium salts of perhalogenoarylboric acid.

In some preferred embodiments of the present invention, the cationic initiator is selected from any one of diaryliodonium salts of hexafluoroantimonic acid and triarylsulfonium salts of hexafluoroantimonic acid, which is beneficial to improve the OD value of the printed pattern and have a better comprehensive performance.

The pigment as the colorant in the aforementioned cationic photocurable composition can be selected from the prior art. The pigment may be an inorganic pigment or an organic pigment, and may be in any color, such as black, blue, brown, cyan, green, white, purple, magenta, red, orange, and yellow, as well as a special color of a mixture thereof. Illustratively, the organic pigment is selected from any one or more of perylenes, phthalocyanine dyes (e.g., phthalocyanine green, phthalocyanine blue), cyanine pigment (e.g., Cy3, Cy5, and Cy7), naphthalocyanine pigments, nitroso pigments, azo pigments, diazo pigments, diazo condensation pigments, basic dye pigments, basic blue pigments, indigo pigments, phloxin pigments, quinacridone pigments, isoindolinone pigments, dioxazine pigments, carbazole dioxazine violet pigments, alizarin lake pigments, phthaldiamide pigments, carmine lake pigments, tetrachloroisoindolinone pigments, perinone pigments, anthraquinone pigments, and quinophthalone pigments; and the inorganic pigment is selected from any one or more of titanium oxides (e.g., titanium dioxide, conductive titanium dioxide), iron oxides (e.g., red iron oxide, yellow iron oxide, black iron oxide, and transparent iron oxide), aluminum oxides, silicon oxides, carbon black pigments, metal sulfides, and metal chlorides.

In order to further improve the photosensitivity of the cationic photocurable composition, the aforementioned cationic photocurable composition further comprises a sensitizer. The specific type and amount of the sensitizer can be determined according to the prior art. In some embodiments of the present invention, the content of the sensitizer in the cationic photocurable composition is 0.1 wt% to 10wt%, preferably 3 wt% to 8 wt%, such as 4 wt%, 5 wt%, 6 wt%, 7 wt%, and the cationic photocurable composition has a better photosensitivity and comprehensive performance.

In some embodiments of the present invention, the aforementioned sensitizer includes any one or more selected from thioxanthone compounds, xanthone compounds, acridine compounds, anthracene compounds, and coumarin compounds; preferably, the sensitizer is selected from any one or more of anthracene compounds and thioxanthone compounds, such as JRCure-1105(ITX) and JRCure-1106(DETX) produced by Tianjin Jiuri New Materials Co., LTD, and PSS303, PSS306, PSS510, PSS513, PSS515, PSS402, PSS403, PSS603 produced by CHANGZHOU TRONLY NEW ELECTRONIC MATERIALS CO., LTD., and has a better photosensitivity and comprehensive performance when used in combination with the cationic polymerizable compound of the present invention.

In some embodiments of the present invention, in order to further improve the OD value of the ink printed pattern and obtain a clearer pattern, the sum of the contents of the first cationic polymerizable compound and the second cationic polymerizable compound accounts for 30wt% to 60wt%, such as 35wt%, 40wt%, 45wt%, 50wt%, and 55wt% of the total content of the cationic photocurable composition. The amount ratio of the first cationic polymerizable compound to the second cationic polymerizable compound is 1:5 to 3:1, for example 1:5, 1:4, 1:3, 1:2, 2:3, 1:1, 3:2, 2:1, 5:2, 3:1, or the ranges between any two of these.

According to the requirements of the product application environment, the cationic photocurable composition of the present invention may also selectively incorporate organic and/or inorganic auxiliaries commonly used in the art, such as any one or more of levelling agents, dispersants, curing agents, surfactants, defoamers, and storage enhancers. The specific ingredients and amounts of the above auxiliaries can refer to the prior art and are not gone into too much detail here.

The viscosity of the cationic photocurable composition of the present invention is not particularly limited. When the composition is formed into a coating by inkjet printing, the viscosity of the composition is generally appropriately 50 mPa·s or less, preferably 2 to 30 mPa·s. The viscosity of the composition of the present invention can be well controlled during storage, and no additional thickener or thinning agent is required.

For the cationic photocurable composition of the present invention, the form of the initiating energy source is not particularly limited. Under the energy radiation such as ultraviolet light, visible light, infrared light, electron beam, laser, the polymerization reaction can occur and the rapid curing is achieved. Illustratively, the initiating energy source may be ultra-high pressure mercury lamp, high pressure mercury lamp, medium pressure mercury lamp, mercury xenon lamp, low pressure mercury lamp, metal halide lamp, xenon lamp, deuterium lamp, chemical lamp, LED lamp, fluorescent lamp, tungsten lamp, Nd-YAG triple wave laser, He-Cd laser, nitrogen laser, Xe-Cl excimer laser, Xe-F excimer laser, semiconductor excited solid laser, i-ray, h-ray, g-ray, and other active lights, with a wavelength of 200 to 500 nm. The energy curing by electron beam, α-ray, β-ray, γ-ray, X-ray and neutron ray, etc. can also be used in the curing of the composition. A UV mercury lamp or a UV-LED lamp with a wavelength range of 200 to 500 nm is preferable, wherein the radiation energy is preferably 20 to 1000 mJ/cm².When curing using a long wavelength energy source, it is preferred to add a sensitizer into the composition to improve the photosensitivity of the composition.

The components in the cationic photocurable composition of the present invention are evenly mixed, to obtain an active energy ray-curable inkjet ink. The specific preparation process can refer to the preparation processes for the radiation curable compositions in the prior art. Typically, the preparation process includes: batching, pre-dispersing, grinding, and filtering (filtering through a filter screen having a specified size to obtain a product with a desired particle size) under the conditions of constant temperature and humidity and avoiding radiation light sources, i.e., to obtain an inkjet ink.

According to another typical embodiment of the present invention, there is provided use of any of the above cationic photocurable composition in an ink.

The use of the aforementioned cationic photocurable composition as ink can well solve the problem of low OD value of the printed pattern, can achieve high-precision inkjet printing, has excellent curing performances especially significantly improved curing speed, and has good application prospects.

When the aforementioned cationic photocurable composition is used as an ink, its coating method can refer to the prior art without particular limitations. In addition to inkjet printing, other well-known methods can be used, such as dip coating, air knife coating, curtain coating, roller coating, die coating, wire rod coating, and the like.

When the aforementioned cationic photocurable composition is used as an ink, the substrate used is not particularly limited, such as any of films, glasses, and plastics. The surface treatment such as corona treatment can be selectively performed according to the selected substrate material.

For the spray-coated pattern of the cationic photocurable composition of the present invention, the thickness of the cured coating can be adjusted according to the prior art or according to the purpose of use. The thickness of the spray-coated pattern is preferably 0.1 to 10 µm, more preferably 0.5 to 5 µm, resulting in relatively uniform coating as formed and contributing to controlling the costs. This is because when the thickness of the ink coating is too small, the coating may not be formed uniformly, or it is difficult to accurately print according to the design; and when the thickness is too large, the coating may consume a large amount of printed ink thereby increasing costs, it is disadvantageous for uniform application, and the coating may become brittle and prone to delamination.

Hereinafter, the advantageous effects of the present invention will be further illustrated with reference to the examples and comparative examples.

### 1. Formulation of the ink

According to the formulations of the examples and comparative examples as shown in Table 1 and Table 2, the components in the formulations were stirred at a constant speed for 1 hour using a high-speed stirrer under a yellow light lamp condition, then ground using a sand grinder, and then filtered through a filter screen with a particle size of 1 µm, to obtain ink compositions. The quantities in each example and comparative example as shown in the tables are based on parts by weight.

**Table 1**

| Component | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|
| A1 | 10 | | 15 | | 30 | | 30 | | 30 | 30 | 25 | | | |
| A1' | | 15 | | 20 | | 15 | | 20 | | | | 20 | 20 | |
| A1" | | | | | | | | | | | | | | 20 |
| A2 | 20 | | 40 | | 25 | | 25 | | 45 | 28 | 35 | | | |
| A2' | | 20 | | 35 | | 50 | | 35 | | | | 35 | 35 | 30 |
| A3 | | | | | | | | | | | | | | |
| A4 | | | | | | | | | | | | | | |
| A5 | | | | | | | | | | | | | | |
| A6 | | | | | | | | | | | | | | |
| B1 | 55 | | 30 | | 30 | 20 | | | | | | 15 | | |
| B2 | | 50 | | 30 | | | 30 | 32 | 20 | 30 | 25 | | | 35 |
| B3 | | | | | | | | | | | | 15 | 30 | |
| C1 | 6 | | 6 | 6 | 6 | 6 | | 5 | 2 | | | 6 | 6 | 6 |
| C2 | | 6 | | | | | 6 | | | 6 | 6 | | | |
| D1 | 6 | | 6 | 6 | 6 | 6 | 6 | 5 | 2 | 6 | | 6 | 6 | 6 |
| D2 | | 6 | | | | | | | | | 3 | | | |
| E | 3 | 3 | 3 | 3 | 3 | 3 | 3 | 3 | 1 | | 6 | 3 | 3 | 3 |

**Table 2**

| Component | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|
| A1 | 10 | 10 | 10 | 35 | 30 | | | | |
| A1' | | | | | | | | | |
| A2 | 10 | 15 | 10 | 25 | 55 | | | | |
| A2' | | | | | | 35 | 35 | 35 | 35 |
| A3 | | | | | | 20 | | | |
| A4 | | | | | | | 20 | | |
| A5 | | | | | | | | 20 | |
| A6 | | | 65 | | | | | | 20 |
| B1 | 30 | 60 | | | | | | | |
| B2 | 40 | | | 25 | | 30 | 30 | 30 | 30 |
| C1 | 5 | 6 | 6 | | | 6 | 6 | 6 | 6 |
| C2 | | | | 6 | 6 | | | | |
| D1 | 2 | 6 | 6 | 6 | 6 | 6 | 6 | 6 | 6 |
| D2 | | | | | | | | | |
| E | 3 | 3 | 3 | 3 | 3 | 3 | 3 | 3 | 3 |

The components represented by the letters in the tables are as follows: wherein A1, A1', and A1'' are compounds of Structural Formula I; A2 and A2' are compounds of Structural Formula II; B1 and B2 are epoxy compounds; B3 is an oxetane compound; C1 and C2 are cationic initiators; D1 and D2 are pigments; and E is a sensitizer.
A1: 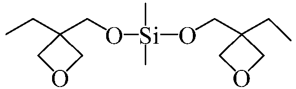 (homemade in accordance with the synthesis method disclosed in GB2393444A);
A1': 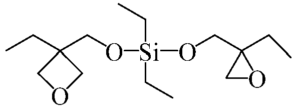 (homemade in accordance with the synthesis method disclosed in CN1930213A);
A1": 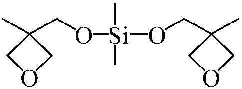 (homemade in accordance with the synthesis method disclosed in US4342681A);
A2: 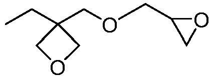 (homemade in accordance with the synthesis method disclosed in US3452054A);
A2': 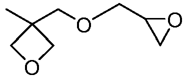 (homemade in accordance with the synthesis method disclosed in JP3047800B2);
A3: 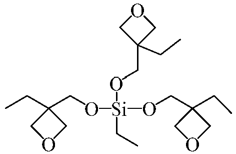 (homemade in accordance with the synthesis method disclosed in US4456717A);
A4: 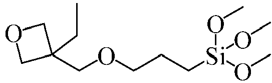 (homemade in accordance with the synthesis method disclosed in FR1397043A);
A5: 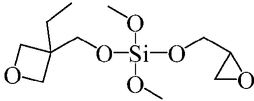 (homemade in accordance with the synthesis method disclosed in US3457193A);
A6: 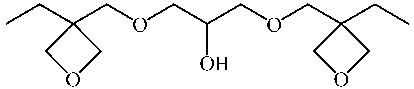 (homemade in accordance with the synthesis method disclosed in US20200270236A1);
B1: 3,4-epoxycyclohexylmethyl-3',4'-epoxycyclohexyl carboxylate (product code: TTA21);
B2: 2,2'-[(1-methylethylene)bis(4,1-phenylenecarboxaldehyde)]bisoxirane (CHANGZHOU TRONLY NEW ELECTRONIC MATERIALS CO., LTD.);
B3: 3-ethyl-3-(benzyloxymethyl)oxetane (CHANGZHOU TRONLY NEW ELECTRONIC MATERIALS CO., LTD.);
C1: bis(dodecylphenyl)iodonium hexafluoroantimonate (CHANGZHOU TRONLY NEW ELECTRONIC MATERIALS CO., LTD.);
C2: thioparaphenylenebis(4,4'-dimethyldiphenylsulfonium) bishexafluoroantimonate (CHANGZHOU TRONLY NEW ELECTRONIC MATERIALS CO., LTD.);
D1: inorganic carbon black (Clariant Chemicals (China) Ltd.);
D2: C.I. Pigment Yellow 155 (Shanghai Shucan Industrial Co. Ltd.);
E1: 9,10-diethoxy-2-ethylanthracene (product code: PSS306).

### 2. Ink curing and drying speed test

The ink to be tested in each example and comparative example was printed using Sotech solvent-free inkjet printer (model: A380), wherein an LED lamp with a wavelength of 395 nm was added to the machine as a radiation light source. The ink to be tested was transferred to a PET film (common industrial film FP2, Lucky Group Corporation) by the inkjet printer, wherein the printing thickness was set to 5 µm, and the LED light source power was 20 mJ/cm².

After the light exposure, it was left for 24 hours, and the surface curing status was evaluated according to the finger touch method in the paint film drying time test standard GB/T 1728-1979, that is, touching the coating lightly with the finger, and confirming the surface dryness by smooth and non-sticky surface without fingerprints when pressed. The drying speed was expressed as the maximum linear speed that achieves the surface drying effect, in m/min, and the test results are shown in Table 3. The curing and drying speed can reflect the activity of the composition. The greater the curing and drying speed, the faster the curing speed and the higher the activity of the composition are.

### 3. Evaluations on the OD value of the cured ink coating, adhesion fastness, and printed product appearance

The linear speeds on the inkjet printer (Inside) were set to 220 m/min and 150 m/min, respectively. The PET film (JPC-P1-125) was used as the substrate, the printing thickness was set to 5 µm, and the irradiation energy of the 395 nm LED light source was 20 mJ/cm². After exposure, it was left for 24 hours, and the basic performances such as the OD value of the cured coating, the adhesion fastness, and the printed product appearance were evaluated, and the evaluation results are shown in Table 3.

### (1) Coating adhesion test

According to "GB/T9286-1998 Scratch Test of Paint and Varnish Film", the adhesion on the substrate was tested by cross-cut (hundred-grid scratching knife) method using QFH paint film grid-scratching instrument. The specific procedure was as follows:
The knife tool that complies with "GB/T9286-1998 Scratch Test of Paint and Varnish Film" was used to cut on the coating surface, to ensure that the scratching reaches the substrate surface each time. The coating surface was cleaned with a soft brush, a tape was applied on the coating such that the tape was in full contact with the coating, and the tape was finally torn from the coating surface, to evaluate the results. The criterions were as follows, and the specific evaluation results are shown in Table 3.
Level 0: The cut edge was completely smooth without one grid falling off;
Level 1: There was a little coating peeling off at the intersection of incisions, with the affected cross-cut areas of not significantly greater than 5%;
Level 2: There was coating peeling off at the intersection of incisions and/or along the edge of incisions, with the affected cross-cut areas of significantly greater than 5% but not significantly greater than 15%;
Level 3: The coating was partially or completely peeled off in large fragments along the cut edge, and/or partially or completely peeled off on different parts of the grids, with the affected cross-cut areas of greater than significantly 15% but not significantly greater than 35%;
Level 4: The coating was peeled off in large fragments along the cut edge, and/or some grids were partially or completely peeled off, with the affected cross-cut areas of significantly greater than 35% but not significantly greater than 65%;
Level 5: The degree for peeling off exceeded Level 4.

### (2) Evaluation on printed product appearance

In accordance with GB/T 7707-2008 inkjet decoration printing standards, the inkjet printing with a depth of 10-18 µm was used. The printed product after being left for 24 hours was placed under the light source for sample viewing as specified in CY/T 3, to identify by visual inspection. The printed product was neat, without obvious ink stains, defects, and knife lines; the text printing was clear and complete, without defects and deformation, and the characters smaller than 7.5P did not affect reading; the full point printing had smooth printing edges and uniform ink color, without obvious watermarks; the printing showed smooth transition, without obvious gradation skips; the dots were clear and uniform, without obvious deformation and defects; the printing hue met the requirements for the printing sample, i.e., it was considered being qualified. Otherwise, it was recorded as disqualified if any item was undesired.

### (3) OD value test

The transmission densitometer X-rite 341C was used in the measurement, and the higher the OD value, the clearer the pattern is.

**Table 3**

| | Curing and drying speed | Adhesion | Appearance | OD value |
|---|---|---|---|---|
| Example 1 | 220 | 0 | qualified | 5 |
| Example 2 | 220 | 0 | qualified | 4.5 |
| Example 3 | 230 | 0 | qualified | 4 |
| Example 4 | 240 | 0 | qualified | 5 |
| Example 5 | 235 | 0 | qualified | 5 |
| Example 6 | 225 | 0 | qualified | 4.5 |
| Example 7 | 230 | 0 | qualified | 4 |
| Example 8 | 220 | 0 | qualified | 4 |
| Example 9 | 225 | 0 | qualified | 4.5 |
| Example 10 | 215 | 0 | qualified | 4 |
| Example 11 | 240 | 0 | qualified | 5 |
| Example 12 | 235 | 0 | qualified | 4.5 |
| Example 13 | 220 | 0 | qualified | 4 |
| Example 14 | 220 | 0 | qualified | 4.5 |
| Comparative Example 1 | 160 | 1 | unqualified | 3.0 |
| Comparative Example 2 | 170 | 1 | qualified | 3.5 |
| Comparative Example 3 | 150 | 1 | qualified | 3.0 |
| Comparative Example 4 | 225 | 1 | unqualified | 3.5 |
| Comparative Example 5 | 200 | 0 | unqualified | 3.0 |
| Comparative Example 6 | 205 | 2 | qualified | 2.5 |
| Comparative Example 7 | 200 | 1 | unqualified | 2.5 |
| Comparative Example 8 | 210 | 1 | qualified | 2 |
| Comparative Example 9 | 175 | 0 | unqualified | 1.5 |

It can be seen from the performance evaluation results in Table 3 that, the use of the aforementioned cationic photocurable composition as ink can well solve the problem that the printed pattern having low OD value, can achieve high-precision inkjet printing, has excellent curing performances, especially significantly improved curing speed, and has good application prospects.

It can be seen from the aforementioned descriptions that, the above examples of the present invention achieve the following technical effects: by applying the technical solution of the present invention, the cationic polymerizable compounds having specific structures are used to combine in a specific proportion while simultaneously adding the epoxy compound or/and oxetane compound. Under the synergistic effect of the above cationic polymerizable compounds and the epoxy compound or/and oxetane compound, the cationic polymerizable composition is not susceptible to be affected by humidity, can effectively improve the dot density fluctuation after the ink landing, and can increase the optical density, so that high-precision images can be formed on various types of recording materials. Also, it has good adhesion and a high curing speed. When being used as an ink, it can effectively expand the range of application for the cationic polymeric ink.

The above descriptions are merely preferred embodiments of the present invention and are not intended to limit the present invention. For those skilled in the art, the present invention may have various modifications and changes. Any modification, equivalent replacement, and improvement made within the spirit and principle of the invention shall be included within the scope of the invention.

## Claims

1. A cationic photocurable composition, **characterized in** comprising: 10-30 parts by weight of a first cationic polymerizable compound, 10-65 parts by weight of a second cationic polymerizable compound, 20-60 parts by weight of an epoxy compound or/and an oxetane compound, 1-10 parts by weight of a cationic initiator, and 2-20 parts by weight of pigment, the first cationic polymerizable compound is any one or more of the compounds shown by Structural Formula I, and the second cationic polymerizable compound is any one or more of the compounds shown by Structural Formula II; 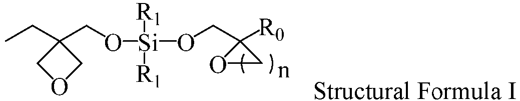 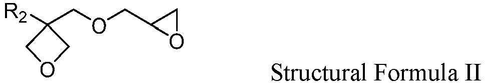
in the formulae, R₀ is selected from any one of hydrogen, methyl, and ethyl, R₁ represents methyl or ethyl, n is 1 or 2; and R₂ represents methyl or ethyl;
the sum of the contents of the first cationic polymerizable compound and the second cationic polymerizable compound accounts for 30 wt% to 75 wt% of the total content of the cationic photocurable composition.

2. The cationic photocurable composition according to claim 1, **characterized in that**, the first cationic polymerizable compound is 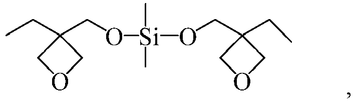 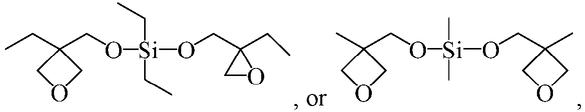 preferably, the second cationic polymerizable compound is 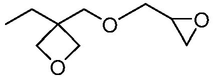 or

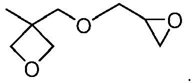

3. The cationic photocurable composition according to claim 1, **characterized in that**, the epoxy compound includes any one or more selected from 3,4-epoxycyclohexylmethyl 3,4-epoxycyclohexylformate, 3,4-epoxycyclohexylmethyl-3,4-epoxycyclohexanecarboxylate, bis(3,4-epoxycyclohexylmethyl)adipate, caprolactone-modified compound of 3,4-epoxycyclohexylmethyl-3,4-epoxycyclohexanecarboxylate, ester compound of polyvalent carboxylic acid with 3,4-epoxycyclohexylmethyl alcohol or caprolactone-modified compound thereof, silicone-based compound having an alicyclic epoxy group at the terminal, bisphenol A diglycidyl ether, bisphenol F diglycidyl ether, brominated bisphenol A diglycidyl ether, phenol novolac epoxy resin, cresol novolac epoxy resin, biphenyl epoxy resin, diglycidyl terephthalate, diglycidyl phthalate, addition reaction product of terminal carboxylic acid polybutadiene with bisphenol A epoxy resin, dicyclopentadiene dioxide, limonene dioxide, 4-vinylcyclohexene dioxide, polyethylene glycol diglycidyl ether, polypropylene glycol diglycidyl ether, polytetramethylene glycol diglycidyl ether, hydrogenated bisphenol A diglycidyl ether, epoxidized vegetable oil, 2-(3,4-epoxycyclohexyl)ethyltrimethoxysilane, 2-(3,4-epoxycyclohexyl)ethyltriethoxysilane, 3-glycidyloxypropyltrimethoxysilane, and 3-glycidyloxypropylmethyldimethoxysilane;
or/and, the oxetane compound includes any one or more selected from 3-benzyloxymethyl-3-ethyloxetane, 3-ethyl-3-(phenoxymethyl)oxetane, 3,3'-[2-(benzyloxy)propane-1,3-dimethoxydiethyloxetane], 3-ethyl-3-methoxyoxetane methacrylate.

4. The cationic photocurable composition according to claim 1, **characterized in that**, the cationic initiator includes an iodonium salt photoinitiator and/or a sulfonium salt photoinitiator;
optionally, the cationic initiator is selected from any one or more of diaryliodonium salts of sulfonic acid, triarylsulfonium salts of sulfonic acid, diaryliodonium salts of boric acid, triarylsulfonium salts of boric acid, diaryliodonium salts of phosphoric acid, diarylsulfonium salts of phosphoric acid, diaryliodonium salts of antimonic acid, and triarylsulfonium salts of antimonic acid.

5. The cationic photocurable composition according to claim 1, **characterized in that**, the pigment is an organic pigment and/or an inorganic pigment, and the color of the pigment includes any one or more of black, blue, brown, cyan, green, white, purple, magenta, red, orange, and yellow.

6. The cationic photocurable composition according to claim 1, **characterized in that**, the cationic photocurable composition further comprises a sensitizer;
preferably, the sensitizer has a content of 0.1 wt% to 10 wt%, preferably 3 wt% to 8 wt%, in the cationic photocurable composition;
preferably, the sensitizer includes any one or more selected from thioxanthone compounds, xanthone compounds, acridine compounds, anthracene compounds, and coumarin compounds; more preferably, the sensitizer is selected from any one or more of anthracene compounds and thioxanthone compounds.

7. The cationic photocurable composition according to any of claims 1 to 6, **characterized in that**, the sum of the contents of the first cationic polymerizable compound and the second cationic polymerizable compound accounts for 30 wt% to 60 wt% of the cationic photocurable composition, and the amount ratio of the first cationic polymerizable compound to the second cationic polymerizable compound is 1:5 to 3:1.

8. The cationic photocurable composition according to any of claims 1 to 6, **characterized in that**, the cationic photocurable composition further comprises an auxiliary, and the auxiliary includes any one or more of levelling agents, dispersants, curing agents, surfactants, defoamers, and storage enhancers.

9. The cationic photocurable composition according to any of claims 1 to 6, **characterized in that**, the viscosity of the cationic photocurable composition is less than 50 mPa·s; preferably, the viscosity is 2 to 30 mPa·s.

10. Use of the cationic photocurable composition according to any of claims 1 to 9 in an ink.

11. The use according to claim 10, **characterized in that**, the substrate used for the ink includes any of film, glass, and plastic;
preferably, the ink has a spraying thickness of 0.1 to 10 µm, more preferably 0.5 to 5 µm.
